**Europäisches Patentamt**

**European Patent Office**

**Office européen des brevets**

(19)

(11) Veröffentlichungsnummer: **0 238 838**
**A2**

(12) **EUROPÄISCHE PATENTANMELDUNG**

(21) Anmeldenummer: **87102211.7**

(22) Anmeldetag: **17.02.87**

(51) Int. Cl.⁴: **B23P 21/00** , B23Q 7/14

(30) Priorität: **18.02.86 US 830702**

(43) Veröffentlichungstag der Anmeldung:
**30.09.87 Patentblatt 87/40**

(84) Benannte Vertragsstaaten:
**AT BE CH DE FR GB IT LI NL SE**

(71) Anmelder: **Mäkinen, Matti**
**Lorettostrasse 57**
**D-7800 Freiburg I Br.(DE)**

(72) Erfinder: **Mäkinen, Matti**
**Lorettostrasse 57**
**D-7800 Freiburg I Br.(DE)**

(74) Vertreter: **Bockhorni, Josef, Dipl.-Ing. et al**
**Piinganserstrasse 18a Postfach 70 02 09**
**D-8000 München 70(DE)**

(54) **Fertigungssystem.**

(57) Die Erfindung betrifft ein Fertigungssystem zur Herstellung von Produkten aus verschiedenen Rohmaterialien und Bauteilen, hauptsächlich für die sogenannte Beleuchtungsindustrie. Rohmaterialien und Bauteile werden auf standardisierten Paletten mittels Förderroboter transportiert und zwar von den Speicherstationen bis zu den Verpackungsstationen, von wo ab die zusammengebauten Produkte weitertransportiert werden. Das Fertigungssystem umfaßt vorzugsweise Vorbereitungsstationen zur Bedienung einer Anzahl von nachfolgenden Zwischenstationen, von denen jede ein Fließband mit einer Anzahl von Arbeitsstationen bedient, die Paarweise auf gegenüberliegenden Seiten eines entsprechenden Fließband-Förderroboters angeordnet sind. Für die Kommunikation zwischen den verschiedenen Stationen sind Display Terminals vorgesehen, sowie Steuereinrichtungen zur Betätigung der Förderer. Auch kann eine voll automatisierte Konstruktion verwirklicht werden.

FIG. 1

EP 0 238 838 A2

## Fertigungssystem

Die Erfindung betrifft ein Fertigungssystem gemäß dem Oberbegriff des Patentanspruches 1.

Fließbandfertigung ist üblicherweise in verschiedene Fertigungsstufen, Zwischenprüfungen und Kontrollen unterteilt. Ein Produkt kann aus 20 bis 2000 Komponenten oder Bauteilen bestehen, wobei die Produktgröße mit fortschreitender Herstellung zunimmt.

Nach heutigen Gesichtspunkten kommt der Qualität immer größere Bedeutung zu. Da die Bauteile in ihrer Größe abnehmen, muß deren handhabung immer genauer werden. Ferner gilt, daß die Kosten um so höher sind, je später in den Fertigungsstufen ein Fehler bekannt wird.

Vorbekannte Fertigungssysteme sind inflexibel und beinhalten einen großen Anteil an manueller Montagearbeit, wie etwa die Anordnung von Komponenten oder Bauteilen auf Schaltplatten, Verlöten und Prüfvorgänge.

Aufgabe der Erfindung ist es, ein Fertigungssystem zu schaffen, welches flexibel ist und mit dem die manuelle Arbeit entweder voll automatisiert werden kann oder diese Stufen beträchtlich durch die Verwendung verschiedener automatischer Werkzeuge beschleunigt werden kann, um die Produktivität durch Beschleunigung des Materialvorbeilaufes, d. h. des Produktdurchlaufes durch das System zu erhöhen.

Diese Aufgabe wird erfindungsgemäß durch die im kenn zeichnenden Teil des Patentanspruches 1 enthaltenen Merkmale gelöst.

Zusätzlich können die Arbeitsstationen Prüfvorrichtungen zur Überprüfung des hergestellten Produktes aufweisen und die Arbeitsstation so ausgebildet sein, daß sie automatisch betrieben werden kann.

Ausgehend von lediglich einem Fließband kann das erfindungsgemäße System in vorteilhafter Weise nach und nach vergrößert werden. Wenn für komplizierte Produkte eine große Menge an unterschiedlichen Bauteilen (Rohmaterialien) und Montagevorgänge erforderlich ist, wird das System zweckmäßigerweise durch die im Anspruch 4 enthaltenen Merkmale ausgebildet.

Zweckmäßigerweise erfolgt der gesamte materialfluß auf Paletten von Standardformat, jedoch mit unterschiedlicher Gestaltung entsprechend des Bedarfes. Die Bewegungen der Paletten sind vorzugsweise automatisiert und die Paletten können über den gesamten Transport gegen Schmutz und Staub geschützt sein.

Nachfolgend wird ein Ausführungsbeispiel der Erfindung anhand der Zeichnung beschrieben. Darin zeigen

Fig. 1 eine Schemaansicht des Fertigungssystemes,

Fig. 2 ein Fließ-oder Montageband, gesehen von einer dazwischenliegenden Bearbeitungsstation,

Fig. 3 eine Fertigungsstraße vom Bearbeitungsende aus,

Fig. 4 eine im Fertigungssystem verwendete Palette sowie

Fig. 5 eine automatische Arbeitsstation.

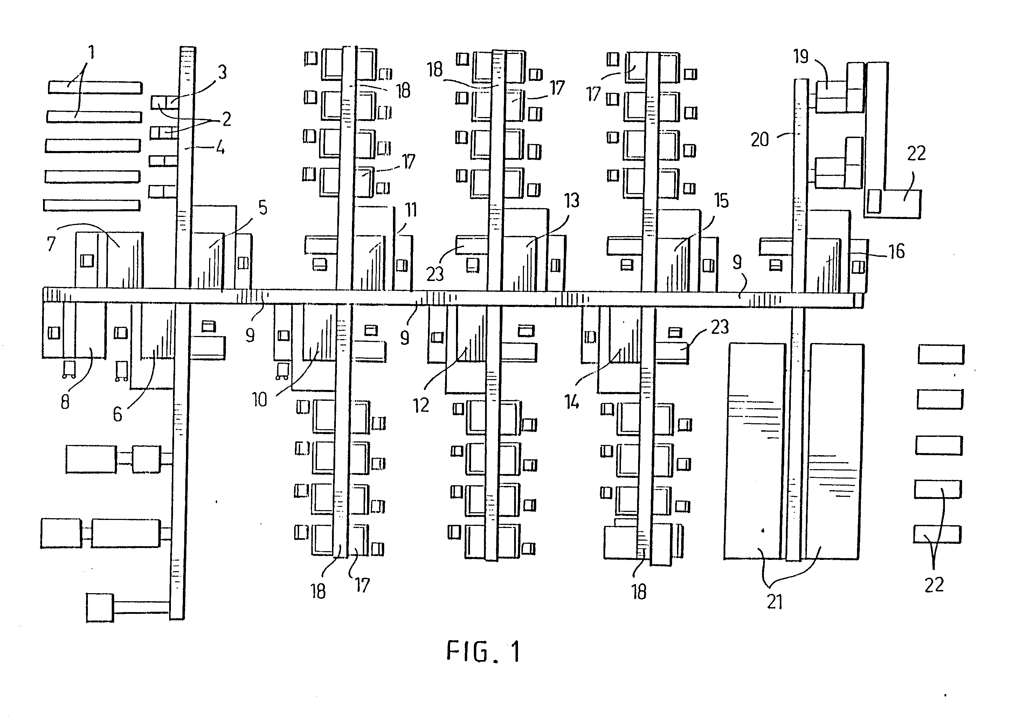

In den Zeichnungen ist mit dem Bezugszeichen 1 ein Speicher für Halbfabrikate und Rohmaterialien angegeben. Mit den Bezugszeichen 2 sind Paletten zur Aufnahme von Halbfertigfabrikaten und Rohmaterialien bezeichnet, wobei diese Paletten durch Förderer 3 zu einem ersten automatischen Förderer 4 (robot conveyor) gefördert werden. Produktionsvorbereitungsstationen sind mit dem Bezugszeichen 5, 6, 7 und 8 bezeichnet. An diesen vorbereitungsstationen werden Komponenten bzw. Bauteile sortiert, beispielsweise gemäß der Größe der Produktionsstelle, und Werkzeuge und Ausrüstung werden aufbewahrt und für die Verteilung bereitgehalten. Beim Aufbau nach Fig. 1 bedient der erste automatische Förderer 4 die Vorbereitungsstationen 5 und 6, wohingegen die Vorbereitungsstationen 7 und 8 in sonst einer Weise bedient werden oder im wesentlichen zur Handhabung der vorgenannten Werkzeuge und Ausrüstungsgegenstände dienen.

Die Komponenten, Ausrüstung und Werkzeuge, die bei der Produktion verwendet werden, variieren erheblich in ihrer Größe, Menge und Form. Dieses Material reicht von Drähten bis zu winzigen Beilagscheiben und empfindlichen elektronischen Bauteilen und erfordert ein System eigener Art, in das es gepackt wird, wie die Produktion fortschreitet.

Um eine flexible Fertigung zu gewährleisten muß das Produkt einfach in der Bearbeitungsstation bewegbar sein. Es muß in jeder Richtung gedreht werden können.

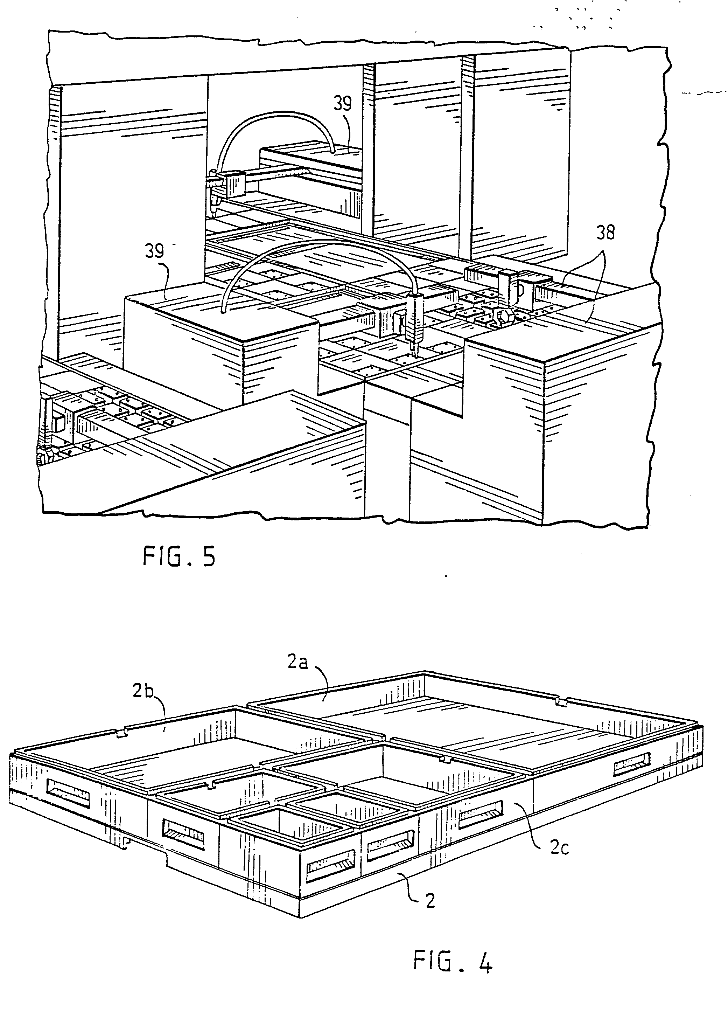

Beim vorliegenden System bewegt sich der gesamte Materialfluß auf Paletten von Standardformat. Ein solcher Palettenaufbau ist in Fig. 4 dargestellt und umfaßt eine Grund palette 2, auf der Kästen bzw. Boxen 2a, 2b, 2c etc. unterschiedlicher Größen für Komponenten und Ausrüstungsgegenstände entsprechend des Bedarfes angeordnet sind. Für spezielle Arbeitsbewegungen und Positionen können zusätzliche Multifunktions-Paletten und Kästen verwendet werden. Ein Vorteil eines solchen standardisierten Palettensystems ist dessen Eignung für einen automatischen Betrieb und eine automatische Fertigung, bei der die Anforderungen an die Genauigkeit der Dimension und der Positionierung strenger sind als im Falle von Handarbeit.

Von den Vorbereitungsstationen aus fördert ein zweiter automatischer Förderer 9, der im folgenden als Hauptförderer bezeichnet ist. Längs des Hauptförderers sind eine Anzahl von zwischenliegenden Bearbeitungsstationen 10 bis 16 angeordnet, von denen jede Zwischenstation 10 bis 15 ein Fließband mit beispielsweise acht Arbeitsstationen 17 mittels eines dritten automatischen Förderers 18 bedient, der im folgenden als Fließbandförderer bezeichnet wird. Die Zwischenstation 16 am Ende des Fertigungssystems bedient beispielsweise zwei Verpackungsstationen 19 mittels eines automatischen Förderers 20, ähnlich den Fließbandförderern. Der automatische Förderer 20 kann vorzugsweise auch eine Station bedienen, in der beispielsweise die Produkte unter Wärmeblöcken 21 getestet werden. von den Verpackungsstationen werden die verpackten Gegenstände zu Blöcken 22 für den weiteren Transport geliefert. Block 23 gibt eine Position für die Überwachung des Personals an, welche jedoch in vielen Fällen überflüssig ist.

Die Förderroboter 18', die sich längs der Fließbänder bewegen, sind so angeordnet, daß sie automatisch für den zwischen den Arbeitsstationen 17 und den entsprechenden Zwischenstationen mittels Paletten 2 stattfindenden Transport Sorge tragen, wobei der Hauptförderroboter 9' für den Transport der Paletten mit Rohmaterial und Bauteilen zu den Zwischenstationen und für den Transport des zu fertigenden Produktes auf den Paletten 2 von einer Zwischenstation zu einer anderen und schließlich zur Verpackungsstation vorgesehen ist. Die Förderroboter 4, 9' und 18' sind lediglich dann in Bewegung, wenn es erforderlich ist, und können mit Einrichtungen 40 zum Schutz der Paletten gegen Staub und Feuchtigkeit versehen sein.

Die zwischenliegenden Bearbeitungsstationen bzw. Zwischenstationen 10-16 umfassen einen Paternoster 25, der mit Fächern 26 versehen ist für die Zwischenspeicherung von Paletten mit Rohmaterial und Bauteilen, die von den Vorbereitungsstationen 5 bis 8 kommen, sowie von Paletten 2 mit Halbfertigfabrikaten, die von den Fließbändern mittels der Förderroboter 18' her geführt werden. Ferner umfaßt die Zwischenstation 8 einen Speicher 27 für Leerpaletten.

Die Arbeitsstationen 17 in jedem Fließband sind paarweise auf gegenüberliegenden Seiten des Förderers 18 angeordnet, der sich zwischen diesen erstreckt. Die aufeinander zuweisenden Arbeitsstationen sind spiegelbildlich angeordnet, wodurch mehrere Paare von Arbeitsstationen 17 nebeneinander längs des seitlichen Förderers 19 vorhanden sind. Jedes Paar von Arbeitsstationen 17 hat eine gemeinsame Tischfläche 28, wobei der mittlere Abschnitt hiervon für die Bewegung des Förderroboters 18' und für die zu verschiebenden Paletten 2 reserviert ist. Jede Arbeitsstation 17 umfaßt eine durch eine Steuereinrichtung 29 der Arbeitsstation betätigte Hubeinrichtung, um das hereinkommende Rohmaterial und die mit Bauteilen versehenen Paletten 2 in einen Palettenspeicher 30 der Arbeitsstation zu bringen und die Paletten aus dem Speicher 30 auf die Höhe der Tischfläche 28 zu heben. Prüfeinrichtungen für Zwischenprüfungen der herzustellenden Produkte können in Verbindung mit einer Arbeitsstation 17 positioniert werden. Die Fließ bänder können voll automatisiert sein, wodurch Bedienungsleute 37 von automatischen Montagerobotorn an den Arbeitsstationen 17 ersetzt werden.

Die Steuerlogik derartiger Montageroboter 38 und 39 ist mit der Steuereinrichtung 29 der Arbeitsstation verbunden, wie schematisch in Fig. 5 dargestellt ist.

Das Fertigungssystem arbeitet wie folgt:

Der automatische Förderer 4 bringt die Paletten 2 mit den Bauteilen und dem Rohmaterial aus dem Speicher 1 zu den Produktionsvorbereitungsstationen 5-8, wo die in den Paletten 2 enthaltenen Güter sortiert werden, so daß sie zu den Zwischenstationen 10-15 geleitet werden können. Mittels Display Terminals werden von den Zwischenstationen zu den Vorbereitungsstationen Meldungen gegeben, die benötigte Materialien und Werkzeuge betreffen, welche hiernach von der Vorbereitungsstation 6 zur entsprechenden Zwischenstation mittels des Hauptförderroboters 9' auf Paletten 2 geführt werden. Die Materialien und Werkzeuge enthaltenden Paletten 2 werden an der entsprechenden Zwischenstation auf Fächern 26 des Paternosters 25 gespeichert. Die Arbeitsstationen 17 kommunizieren mit den Display Terminals 34 der entsprechenden Zwischenstation, wodurch eine Nachricht hinsichtlich des erforderlichen Materials von jeder Arbeitsstation 17 zur Zwischenstation gesandt werden kann, wobei die Materialien vom Förderroboter 18' zur Arbeitsstation 17 geführt werden. Der Förderroboter 18' transportiert auch die leeren Paletten 2 oder ein montiertes Produkt auf einer Palette 2 aus der Arbeitsstation 17 zur Zwischenstation, wo die Leerpaletten 2 in dem Speicher 27 gespeichert und ein auf einer Palette 2 angeordnetes Produkt mittels des Hauptförderers 9 zu einer folgenden Zwischenstation transportiert wird. Wenn eine das zusammenzubauende Produkt tra gende Palette 2 durch sämtliche erforderlichen Montagebänder und Zwischenstationen geführt wurde, kommt die Palette an der Verpackungsstation 19 an, wo das fertiggestellte und verpackte Produkt dann zu einem Speicher für den weiteren Transport bewegt wird.

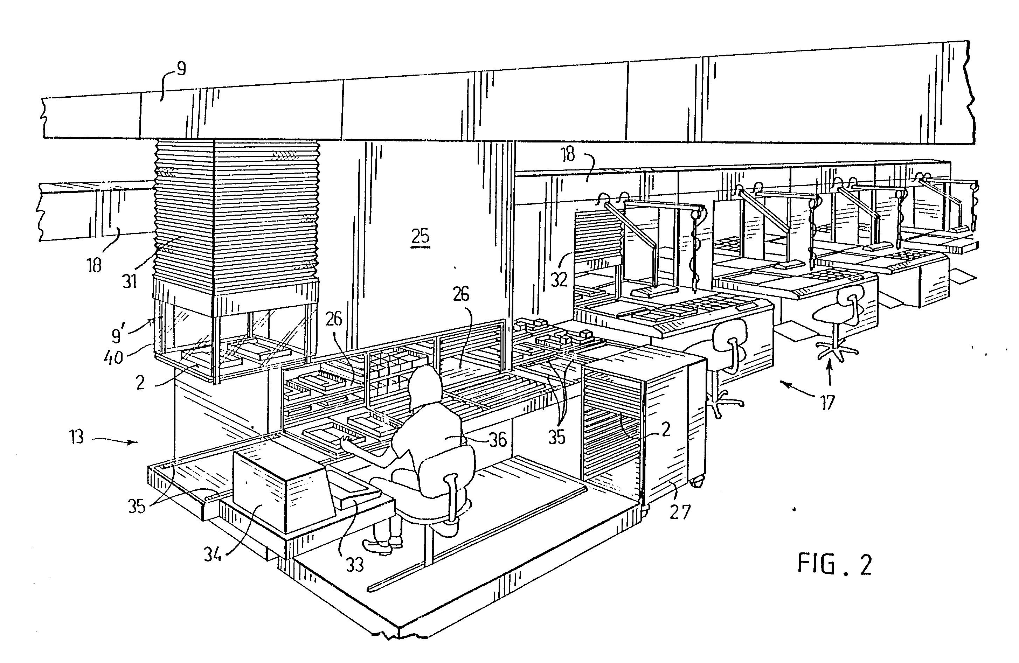

An jeder der Zwischenstationen 10-15 und jeder Arbeitsstation 17 sind die Förderroboter 9' und 18' jeweils auf-und abbeweglich, geführt durch Balgen 31 und 32, sowie durch Steuereinrichtungen 33 und 29 betätigt. Das Bezugszeichen 34 an der in Fig. 2 dargestellten Zwischenstation gibt einen Display Terminal an, durch das der Bedienungsmann mit den Vorbereitungsstationen, anderen Zwischenstationen und mit den entsprechenden Arbeitsstationen 17 des Fließbandes kommuniziert. Das Bezugszeichen 35 gibt Förderbänder an, die auf die Ränder der Paletten 2 einwirken, um eine gewünschte Bewegung der Paletten auf den Arbeitstischen sowohl an den Zwischenstationen 10-15 und an den Arbeitsstationen zu bewerkstelligen. An der Zwischenstation 13 werden die Paletten 2 links vom Bedienungsmann 36 aufgenommen, der entweder die Paletten im Paternoster 25 speichert oder die Paletten unmittelbar oder von den Paternosterfächern 26 nach rechts und um die Ecke des Paternosters 25 überführt, wo dann der Förderrobotor 18' diese aufnimmt, beispielsweise mittels Paletteneckgreifern, die nicht dargestellt sind, und diese zur entsprechenden Arbeitsstation 17 führt.

Der Bedienungsmann 36 kann in derselben Weise wie nach der Fig. 5 für eine Arbeitsstation von einem Roboter ersetzt werden.

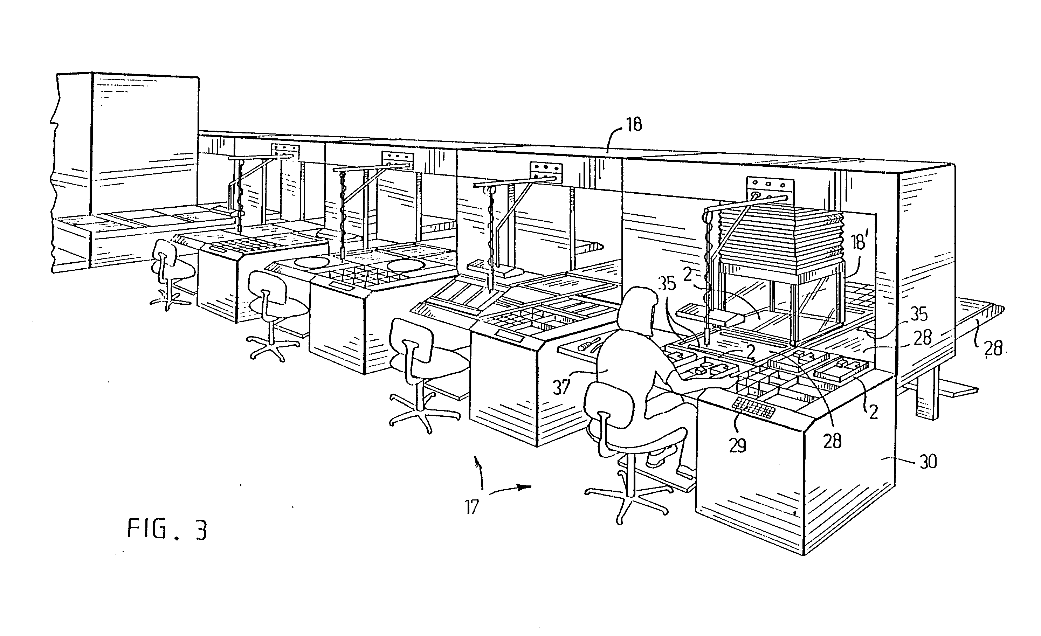

Fig. 3 zeigt die ähnliche Palettenhandhabung an einer Arbeitsstation 17. Der Roboter 18' übergibt die Paletten 2 in der Mitte eines Arbeitstisches 28 gemeinsam für zwei gegenüberliegende Arbeitsstationen und der bedienungsmann 37 bringt die Paletten zur Bewegung, die von den randseitigen bandförderern 35 geführt werden, die an den Rändern der nach den Paletten dimensionierten Abschnitten des tisches 28 angeordnet sind, und zwar unter Verwendung der Steuereinrichtung 29.

Dieselbe steuereinrichtung 29 wird für die Bedienung der zuvor erwähnten Hubeinrichtung für Paletten verwendet, welche im Palettenspeicher 30 angeordnet und deshalb in Fig. 3 nicht ersichtlich ist. Die Palettenhubeinrichtung kann selbstverständlich ebenso von robotern 38 und 39 bedient werden, wie sie in Fig. 4 dargestellt sind.

Der Transport der paletten aus der Arbeitsstation 17 zu einer Zwischenstation 13 erfolgt in derselben weise, jedoch in entgegengesetzten Richtungen. An den Vorbereitungsstationen 5-8 findet die Handhabung bzw. Bearbeitung der Materialien (Paletten) in derselben Weise wie in den Zwischenstationen statt.

## Ansprüche

01. Fertigungssystem für den Zusammenbau eines Produktes aus einer Vielfalt von Bauteilen, **gekennzeichnet** durch mindestens ein Fließband mit einer Anzahl von Arbeitsstationen (17), die mit den erforderlichen Werkzeugen für die Ausführung vorbestimmter Montagearbeiten versehen sind, mindestens einem automatischen Förderer (18) für die Zufuhr von Bauteilen an die entsprechenden Arbeitsstationen und für die Weitergabe zusammengebauter Produkte von den entsprechenden Arbeitsstationen, eine Steuereinrichtung für den Betrieb des oder dieser Förderer (18) sowie durch Paletten (2) in Standardgröße zur Aufnahme der Bauteile und der zusammengebauten Produkte zwecks Speicherung und Transport durch den Förderer (18), wobei die Arbeitsstationen (17) so angeordnet sind, daß sie auf gegenüberliegenden Seiten des Förderers (18) mindestens ein Paar spiegelbildlich zueinander angeordneter Arbeitsstationen (17) bilden, von denen jedes Paar von eine gemeinsame Tischfläche (28) aufweist, deren zentraler Abschnitt für die Aufnahme der Paletten vom fließbandförderer (18) und für die Zuführung der Paletten (2) hierzu reserviert ist, wobei die gemeinsame Tischfläche (28) in entsprechend den Paletten (2) bemessene Abschnitte unterteilt sowie mit Randförderbändern (35) zur Bewegung der Paletten in gewünschte Richtungen versehen sowie eine Steuereinrichtung für den Betrieb der Förderbänder vorgesehen ist, und wobei jede Arbeitsstation eine Hubeinrichtung aufweist, um ankommende Paletten zu einem Palettenspeicher (30) zu bringen und die Paletten (2) aus dem Speicher auf die Höhe der Tischfläche (28) zu heben.

02. System nach Anspruch 1, dadurch **gekennzeichnet**, daß jede Arbeitsstation (17) Prüfungeinrichtungen zur Prüfung der hergestellten Produkte aufweist.

03. System nach Anspruch 1 oder 2, dadurch **gekennzeichnet**, daß jede Arbeitsstation (17) automatisch betätigbar ist.

04. Fertigungssystem zum Zusammenbau eines Produktes aus einer Vielfalt von Rohmaterialien und Bauteilen, **gekennzeichnet** durch mindestens eine Produktionsvorbereitungsstation (5, 6, 7, 8) für die Sortierung von Rohmaterialien und Bauteilen, die durch einen ersten automatischen Förderer (4) auf Paletten (2) mit Standardformat von einem Speicher (1) herangeführt sind, eine Anzahl von aufeinanderfolgenden Zwischenstationen (10-16), die mit der Vorbereitungsstation über Display Terminals in Verbindung stehen, einen zweiten automatischen Förderer (9) für den Transport von Paletten (2) mit Rohmaterial und Bauteilen an die Zwischenstation (10-16), eine Anzahl von Fließbändern, von denen eines für jede Zwischenstation vorgesehen ist und eine Anzahl von Arbeitsstationen (17) aufweist, die mit den erforderlichen Werkzeugen zur Ausführung von bestimmten Montagearbeiten versehen sind und mit der entsprechenden Zwischenstation (10-16) über Display Terminals in Verbindung stehen, einen Fließband-Automatikförderer (18) für den Transport von mit Bauteilen versehenen Paletten von der entsprechenden Zwischenstation (10-16) und zurück zu dieser und weiter zum zweiten automatischen Förderer (9), eine Steuereinrichtung für den Betrieb des ersten, zweiten und des Fließband-Automatikförderer (4, 9, 18) und durch eine Verpackungsstation (19), die nach den Zwischenstationen (10-16) am Ende des zweiten Automatikförderers (9) angeordnet ist.

05. System nach Anspruch 4,
dadurch **gekennzeichnet**,
daß die Fließbänder quer zum zweiten automatischen Förderer (9) angeordnet sind, und daß der Fließband-Automatikförderer (18) unterhalb des zweiten Automatikförderers (9) angeordnet ist.

06. System nach Anspruch 4 oder 5,
dadurch **gekennzeichnet**,
daß jede Zwischenstation (10-16) einen Paternoster (25) aufweist, der mit Fächern (26) für die Zwischenspeicherung von Paletten mit Rohmaterial und Bauteilen vorgesehen ist, die von der Vorbereitungsstation (5, 6, 7, 8) durch den zweiten automatischen Förderer (9) herbeigeführt werden, sowie von Paletten mit Halbfertigfabrikaten, die vom Fließband zurück mittels des entsprechenden Fließband-Automatikförderer (18) geführt worden sind.

07. System nach Anspruch 6.
dadurch **gekennzeichnet**,
daß jede Zwischenstation (10-16) einen Speicher (27) für Leerpaletten (2) aufweist.

08. System nach einem der Ansprüche 4 bis 7,
dadurch **gekennzeichnet**,
daß Prüfstationen benachbart den Zwischenstationen (10-16) zur Durchführung von Zwischenprüfungen des herzustellenden Produktes angeordnet sind.

09. System nach einem der Ansprüche 4 bis 8,
dadurch **gekennzeichnet** ,
daß sämtliche automatischen Förderer (4, 9, 18) von derselben Bauart sind.

10. System nach einem der Ansprüche 4 bis 9,
dadurch **gekennzeichnet**,
daß die automatischen Förderer längs Schienen bewegbar sind.

11. System nach einem der Ansprüche 4 bis 10,
dadurch **gekennzeichnet**,
daß die automatischen Förderer einzeln betätigbar sind.

12. System nach einem der Ansprüche 4 bis 11,
dadurch **gekennzeichnet**,
daß die automatischen Förderer (4, 9, 18) Einrichtungen zum Schutz der Paletten (2) von Staub und Feuchtigkeit aufweisen.

FIG. 1

FIG. 2

0 238 838

FIG. 3

FIG. 5

FIG. 4